(19) 

Europäisches
Patentamt
European
Patent Office
Office européen
des brevets

(11) **EP 2 048 927 A2**

(12) **EUROPEAN PATENT APPLICATION**

(43) Date of publication:
**15.04.2009 Bulletin 2009/16**

(51) Int Cl.:
***H05K 7/20*** *(2006.01)*

(21) Application number: **08164932.9**

(22) Date of filing: **23.09.2008**

(84) Designated Contracting States:
**AT BE BG CH CY CZ DE DK EE ES FI FR GB GR
HR HU IE IS IT LI LT LU LV MC MT NL NO PL PT
RO SE SI SK TR**
Designated Extension States:
**AL BA MK RS**

(30) Priority: **10.10.2007 KR 20070102133**

(71) Applicant: **Samsung SDI Co., Ltd.**
**Suwon-si, Gyeonggi-do 442-390 (KR)**

(72) Inventor: **Yeo, Jae-Young**
**Legal & IP Team**
**Suwon-shi,**
 **Gyeonggi-do (KR)**

(74) Representative: **Walaski, Jan Filip et al**
**Venner Shipley LLP**
**20 Little Britain**
**London EC1A 7DH (GB)**

(54) **Printed circuit board assembly and plasma display apparatus including the same**

(57) A plasma display apparatus includes a plasma display panel (PDP). A chassis base supports the PDP. A circuit board is electrically connected to the PDP, is on the chassis base, and applies driving signals to the PDP. Circuit elements are on the circuit board and generate the driving signals. A heat sink contacts the circuit elements to dissipate heat generated by the circuit elements away from the circuit elements. A plurality of grounding portions are spaced apart from one another, are between the heat sink and the circuit board, and ground the heat sink by electrically connecting the heat sink to the circuit board.

**Description**

The present invention relates to a plasma display apparatus, and more particularly, to a plasma display apparatus which reduces emission of electromagnetic waves.

Plasma display apparatuses are flat panel display apparatuses displaying images via light emitted from a discharge space filled with a discharge gas in response to ultraviolet rays generated by applying a predetermined power to electrodes respectively formed on substrates facing each other. Plasma display apparatuses are considered one of the next generation of display devices due to their thinness - less than several centimeters, large screen size and wide viewing angles.

A plasma display apparatus typically includes a plasma display panel (PDP) displaying an image via plasma generated by a gas discharge, a chassis base supporting the PDP, and a circuit board assembly which is mounted on a portion of the chassis base opposite to the PDP, and applies signals to electrodes of the PDP.

The circuit board assembly includes a switching element generating a waveform for providing a sustaining pulse required for driving the PDP. However, the switching element also generates high heat, oscillation, and noise. Thus, the circuit board assembly includes a heat sink to protect the switching element from thermal stress.

Generally, when a heat sink is mounted on a circuit board assembly, the heat sink contacts a plurality of switching elements on the circuit board assembly to simplify manufacturing processes and reduce the number of components in the circuit board assembly. Since the heat sink contacts the switching element, the heat sink receives and dissipates heat generated by the switching element.

PDPs generate strong electromagnetic interference since they are driven by electrical signals having high frequency and voltage. Since electromagnetic waves adversely affect the human body and other electronic devices, the level of electromagnetic waves should be controlled. A PDP driven by a switching element and a circuit board assembly generates noise in a low frequency band (about 30 to 200 MHz). A plasma display apparatus has disadvantageous characteristics when noise at a frequency in the frequency band range of between 30 to 100 MHz is generated.

Also, when an electromagnetic wave generated by driving a switching element contacts a return path formed by a heat sink, the heat sink functions as an antenna that further transmits the electromagnetic wave. If two ends of the heat sink are separated to float from the circuit board assembly, electromagnetic waves emitted by the PDP and the circuit board assembly are transmitted to the heat sink, and the heat sink functions as an antenna for the electromagnetic waves. If the heat sink is grounded via the circuit board assembly, the heat sink functions as a dipole antenna, which increases the emission of electromagnetic waves.

In accordance with the present invention a plasma display apparatus is provided which reduces emission of electromagnetic waves by including a plurality of grounding portions so that a heat sink cannot function as an antenna emitting electromagnetic waves.

According to an aspect of the present invention, a plasma display apparatus includes a PDP. A chassis base supports the PDP. A circuit board is electrically connected to the PDP, is on the chassis base, and applies driving signals to the PDP. Circuit elements are on the circuit board and generate the driving signals. A heat sink contacts the circuit elements to dissipate heat generated by the circuit elements away from the circuit elements. A plurality of grounding portions are spaced apart from one another, are between the heat sink and the circuit board, and ground the heat sink by electrically connecting the heat sink to the circuit board.

An interval at which the grounding portions are spaced apart from one another may be less than 1/20 of a wavelength ($\lambda$) of a frequency at which the maximum emission of electromagnetic wave generated by the circuit elements occurs.

The wavelength ($\lambda$) may be calculated according to the equation

$$\lambda = \frac{C}{f\sqrt{\epsilon\mu}}$$

where "C" is the velocity of light, "$\epsilon$" is permittivity of a medium, "$\mu$" is permeability of a medium, and "f" is a frequency at which the maximum emission of electromagnetic wave occurs.

The grounding portions may protrude from the heat sink towards the circuit board.

The circuit board may include grounding terminals on regions corresponding to the grounding portions.

The circuit board may include through holes respectively housing the grounding portions, and grounding terminals respectively formed in the through holes so as to contact the grounding portions.

According to another aspect of the present invention, there is provided a circuit board assembly which may include one or more circuit board sub-assemblies.
Circuit elements are located on circuit board(s) of the circuit board assembly. A heat sink contacts the circuit elements for dissipating heat generated by the circuit elements away from the circuit elements. A plurality of grounding portions are spaced apart from one another on the heat sink, and are connected to the circuit board to ground the heat sink.

An interval at which the grounding portions may be spaced apart from one another is less than 1/20 of a wavelength ($\lambda$) of a frequency at which the maximum emission of electromagnetic wave generated by the circuit elements occurs.

Embodiments of the invention will now be described by way of example with reference to the accompanying drawings, in which:

FIG. 1 is a partially exploded perspective view of a plasma display apparatus according to an embodiment of the present invention.
FIG. 2 is a partially exploded perspective view of a circuit board assembly included in the plasma display apparatus of FIG. 1, according to an embodiment of the present invention.
FIG. 3 is a front view of the circuit board assembly of FIG. 2, according to an embodiment of the present invention.
FIG. 4 is a chart illustrating noise measured in a conventional device as a comparative example compared with a plasma display apparatus according to an embodiment of the present invention.
FIG. 5 is a chart illustrating noise measured in a plasma display apparatus according to an embodiment of the present invention.

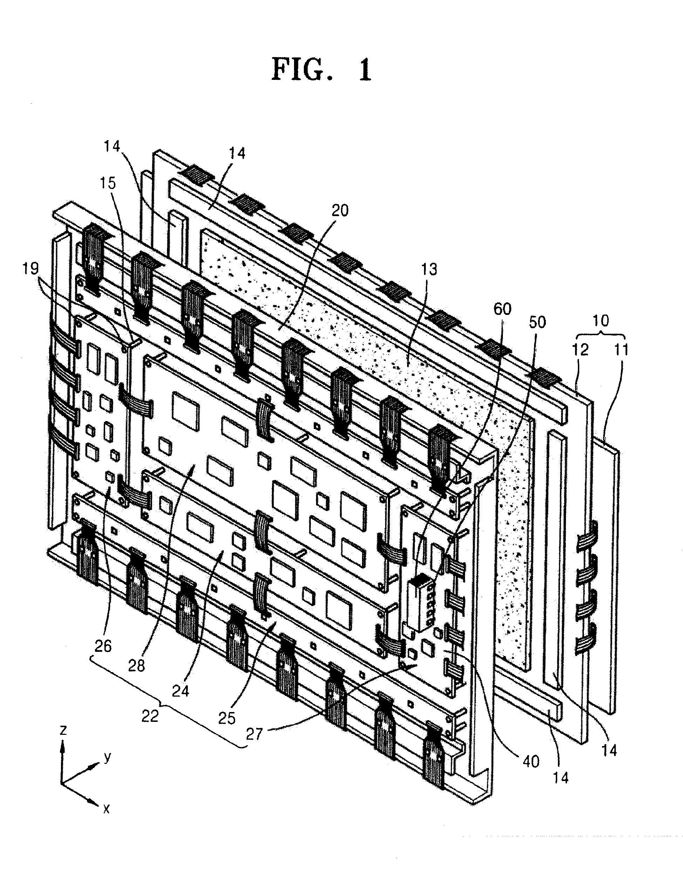

Referring to FIG. 1, the plasma display apparatus according to the present embodiment includes a PDP 10 displaying an image via a gas discharge, a chassis base 20 on a rear surface of the PDP 10, and a circuit board assembly 22 on the chassis base 20.

The PDP 10 includes a top substrate 11 and a bottom substrate 12 which face each other. A plurality of discharge spaces (not shown), which are partitioned by barrier ribs (not shown), are formed between the top substrate 11 and the bottom substrate 12. An address electrode and display electrodes, e.g., a pair of sustain and scan electrodes, cross each other in the discharge space. As a driving signal is applied between an address and a display electrode, a gas discharge occurs in a discharge space, and visible rays are emitted from the discharge space towards the top substrate 11 to display an image as a result of the gas discharge.

The chassis base 20 is mounted behind the bottom substrate 12 of the PDP 10. The chassis base 20 is formed of a material having mechanical rigidity to support the PDP 10.

A heat sink plate 13 and double-sided tape 14 are interposed between a bottom surface of the PDP 10 and a top surface of the chassis base 20. The heat sink plate 13 conducts and dissipates heat, which is generated by the PDP 10 as the result of the gas discharge, in an x-z plane. The heat sink plate 13 may be formed of an acryl-based heat sink material, a graphite-based heat sink material, a metal-based heat sink material or a carbon nanotube-based heat sink material, which has good thermal conductivity.

Since the double-sided tape 14 is used for attaching the PDP 10 to the chassis base 20, the heat sink plate 13 can be closely disposed on the bottom surface of the PDP 10 and the top surface of the chassis base 20.

The circuit board assembly 22 is mounted on a boss 15 of the chassis base 20 by using set-screws 19. The circuit board assembly 22 may include one or more sub-assemblies, such as an image processing/control board assembly 24, an address buffer board sub-assembly 25, a scan driving board sub-assembly 26, a sustain driving board sub-assembly 27, and a switching mode power supply (SMPS) board sub-assembly 28.

The image processing/control board sub-assembly 24 receives an image signal from an external element, and generates control signals required for driving an address electrode, a scan electrode, or a sustain electrode. The generated control signals are respectively applied to the address buffer board sub-assembly 25, the scan driving board sub-assembly 26, or the sustain driving board sub-assembly 27. The address buffer board sub-assembly 25 generates an address pulse, and applies the address pulse to the address electrode of the PDP 10. The scan driving board sub-assembly 26 generates a scan pulse, and applies the scan pulse to the scan electrode of the PDP 10. The sustain driving board sub-assembly 27 generates a sustain pulse, and applies the sustain pulse to the sustain electrode of the PDP 10. The SMPS board sub-assembly 28 supplies power required for driving the PDP 10.

The circuit board assembly 22 is mounted on a surface of the chassis base 20, which is opposite to the PDP 10. Each of the image processing/control board sub-assembly 24, the address buffer board sub-assembly 25, the scan driving board sub-assembly 26, the sustain driving board sub-assembly 27, and the switching mode power supply (SMPS) board sub-assembly 28 includes a circuit board 40 electrically connected to the PDP 10, circuit elements 50 that are on the circuit board 40 and generate a driving signal, and a heat sink 60 contacting the circuit elements 50.

Since the address electrode and the display electrode of the PDP 10 are electrically connected to the circuit board 40 via a signal cable, the circuit board 40 provides a driving signal generated by the circuit elements 50 to the PDP 10. Thus, the circuit board 40 can control the gas discharge that occurs in the discharge spaces of the PDP 10.

The circuit elements 50 (e.g., a field effect transistor (FET), a diode or the like) are on the circuit board 40. In the present embodiment, the circuit board 40 is typically a printed circuit board (PCB), and the circuit elements 50 are mounted on the PCB.

The circuit elements 50 generate driving signals for driving the PDP 10. Since the circuit elements 50 emit much heat when the driving signals are generated, and the PDP 10 also emits much heat, the circuit elements 50 undergo high temperature stress. Accordingly, the heat sink 60 for heat dissipation of circuit elements 50 is put on the circuit board 40.

The heat sink 60 contacts the circuit elements 50 to dissipate heat generated from the circuit elements 50 away from the circuit elements 50 such that the circuit elements 50 can continue to perform their normal operation.

In FIG. 1, the circuit elements 50 and the heat sink 60 are only shown on the sustain driving board sub-assembly 27 in FIG. 1. However, the circuit elements 50 and the heat sink 60 may be on the image processing/control board sub-assembly 24, the address buffer board sub-assembly 25, the scan driving board sub-assembly 26, or the SMPS board sub-assembly 28. In addition, a FET is illustrated as an example of the circuit elements 50, but the present invention is not limited thereto. That is, the heat sink 60 may be attached to a circuit element such as a diode.

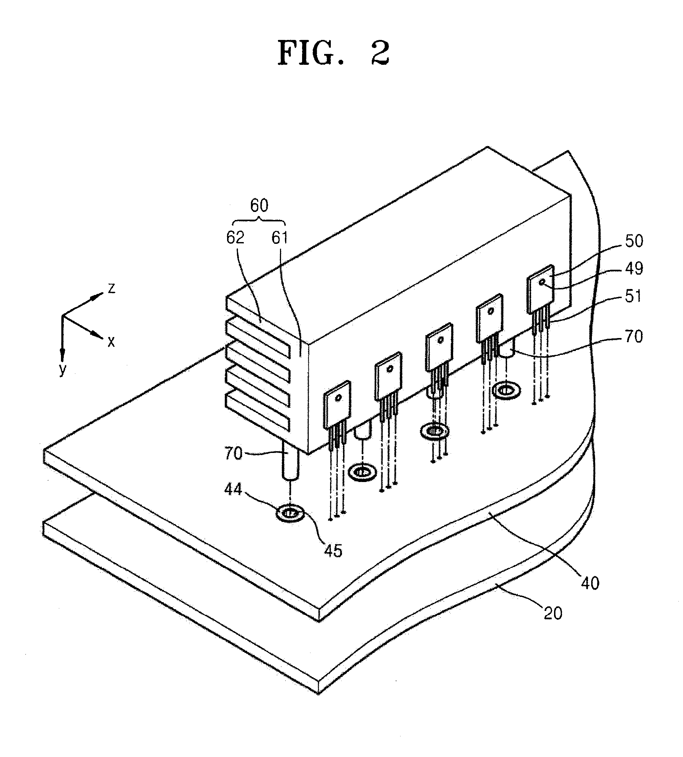

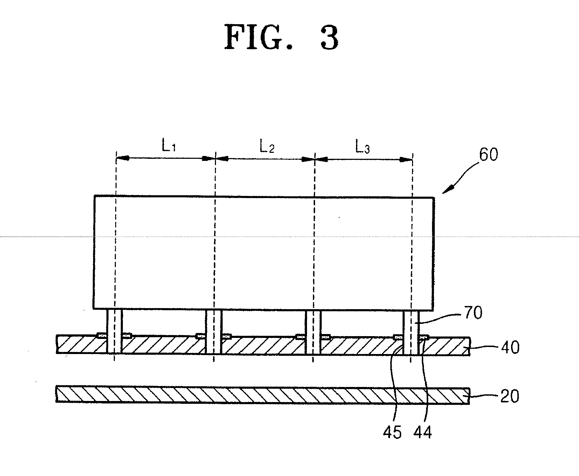

Referring now to FIGs. 2 and 3, the circuit board 40 of the sustain driving board sub-assembly 27 is shown on a bottom surface of the chassis base 20 (i.e., in a negative direction of y-axis in FIG. 2). The circuit elements 50 are mounted on the circuit board 40. Leads 51 extend from one end of the circuit elements 50, and are electrically coupled to the circuit board 40.

The heat sink 60 is coupled to one side surface of the circuit board 40. The circuit elements 50 are coupled to the heat sink 60 by using the set-screws 49. In particular, the heat sink 60 includes a heat sink plate 61, and a plurality of heat sink fins 62 extending outwards from the heat sink plate 61. The circuit elements 50 are coupled to the heat sink plate 61.

The heat sink plate 61 contacts the circuit elements 50. The heat sink fins 62 dissipate heat transmitted by the heat sink plate 61 since the heat sink fins 62 are in contact with air. The heat sink fins 62 may be formed parallel to a flow direction of air (i.e., a z-axis direction in FIG. 2).

A plurality of ground portions 70 for electrically connecting the heat sink 60 to the circuit board 40 are formed on the heat sink 60. The ground portions 70 are coupled to ground terminals 44 formed in the circuit board 40, thereby grounding the heat sink 60.

The ground portions 70 are formed on the heat sink 60 so as to be spaced apart from one another at predetermined intervals, such as intervals L1, L2, L3 as seen in FIG. 3. The ground portions 70 are formed integrally with the heat sink 60, but the present invention is not limited thereto. As described above, the ground portions 70 electrically connect the heat sink 60 to the circuit board 40 thereby grounding the heat sink 60. Thus, the grounding portions 70 may be each a connection terminal protruding from the circuit board 40, or a connection means formed of a conductive material and between the circuit board 40 and the heat sink 60.

The ground portions 70 electrically connect the heat sink 60 to the circuit board 40, and fix the heat sink 60 to the circuit board 40. To achieve this, the circuit board 40 includes through holes 45 that respectively house ends of the ground portions 70 and that are respectively formed in the centers of the ground terminals 44. Thus, when the ground portions 70 are respectively inserted into the through holes 45 of the circuit board 40, the heat sink 60 is fixed to the circuit board 40 and electrically connected to the circuit board 40 through the ground terminals 44 thereby grounding the heat sink 60.

The ground portions 70 are spaced apart from one another at the predetermined intervals to prevent electromagnetic waves from emitting due to the heat sink 60. An interval at which the ground portions 70 are spaced apart from one another may be less than 1/20 of a wavelength corresponding to a frequency at which the maximum emission of electromagnetic waves, which is generated by the circuit elements 50, is measured. It is generally known that an antenna having a length of 1/20 of or more than the wavelength of any electromagnetic wave emits electromagnetic waves. Thus, the interval at which the ground portions 70 are spaced from one another is less than 1/20 of the wavelength of the electromagnetic wave generated by the circuit elements 50 so that the heat sink 60 may not function as an antenna radiating electromagnetic waves.

The maximum emission of electromagnetic waves, which corresponds to the intensity of sustain noise generated while a sustain pulse signal is applied by the sustain driving board sub-assembly 27, has been measured at a frequency of 80 MHz.

When a frequency of a frequency band in which the maximum emission of electromagnetic waves is measured, is f(Hz) and a wavelength is λ(m), a velocity ν($^m/_s$) of the electromagnetic waves is defined as an Equation 1.

$$v = f \times \lambda \tag{1}$$

When the velocity of light is C ($^m/_s$), permittivity is "ε" of a medium, and permeability is "μ" of a medium, the velocity "v" of an electromagnetic wave is defined as an Equation 2.

$$v = \frac{C}{\sqrt{\epsilon\mu}} \tag{2}$$

Thus, based on Equations 1 and 2, a wavelength of a frequency at which the maximum emission of electromagnetic waves is measured, is calculated by using Equation 3.

$$\lambda = \frac{C}{f\sqrt{\epsilon\mu}} \tag{3}$$

When C = 3 × 10$^8$ m/s, εμ = 4, and f=80 MHz are inserted in Equation 3, the wavelength of the electromagnetic wave is calculated as Equation 4.

$$\lambda = \frac{(3 \times 10^8)}{(80 \times 10^6)\sqrt{4}} = 1.875\,(\text{m}) \tag{4}$$

$$\frac{\lambda}{20} = 93.75\,(\text{mm}) \tag{5}$$

Thus, intervals L1, L2, and L3 at which the ground portions 70 are spaced apart from one another would be less than 93.75 mm. In addition, since the ground portions 70 are spaced apart from one another, a minimum interval between the ground portions 70 is more than 0 mm. According to an interval between the ground terminals 44 included in the circuit board 40, the interval at which the ground portions 70 are spaced apart from one another would be 16 mm or more, which is 1/117 of the wavelength. Likewise, when the interval at which the ground portions 70 are spaced apart from one another is more than 0 and less than 93.75 mm, since the heat sink 60 cannot function as an antenna emitting electromagnetic waves, the emission of electromagnetic waves can be reduced.

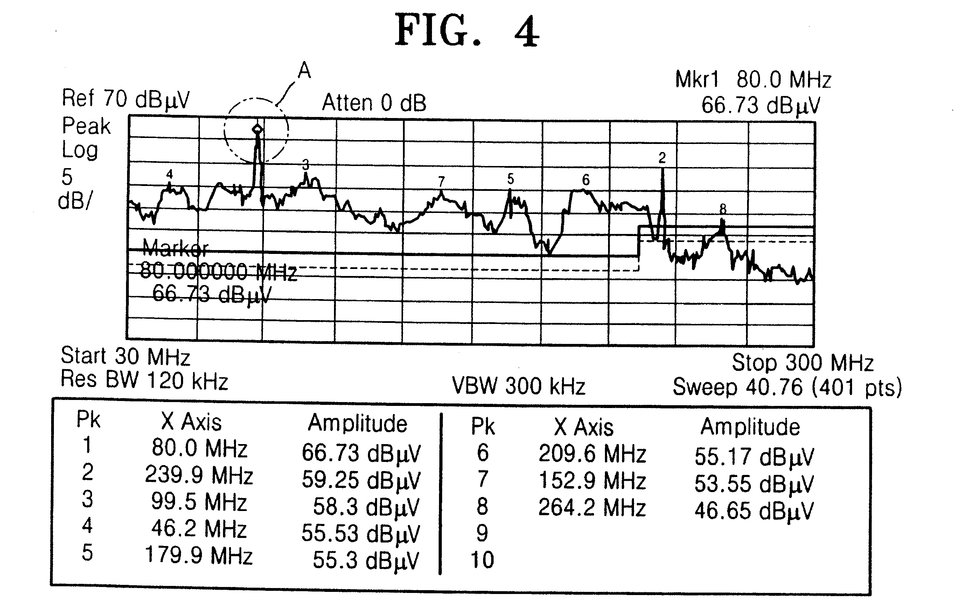

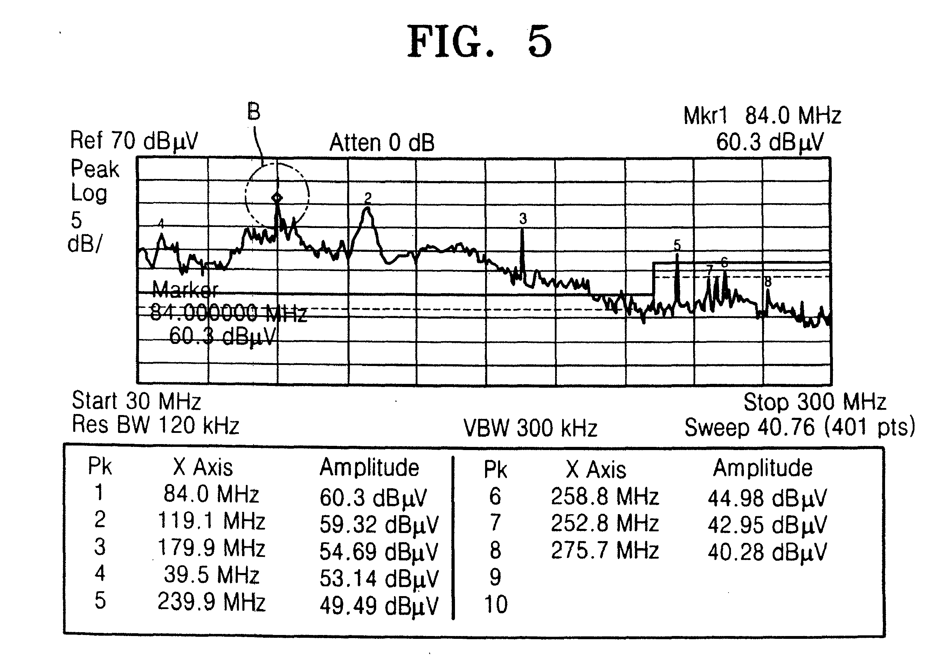

FIG. 4 is a chart illustrating noise measured in a conventional device as a comparative example compared with a plasma display apparatus according to an embodiment of the present invention. FIG. 5 is a chart illustrating noise measured in a plasma display apparatus according to an embodiment of the present invention.

Referring to FIG. 4, conventional technologies, in which a grounding structure of a heat sink is not improved, are used in the plasma display apparatus in which the noise is measured. The length of the heat sink of the plasma display apparatus is about 40 cm. A distance between grounding points is 40 cm, which is the length of the heat sink. Analysis of FIG. 4 shows that the intensity of an electromagnetic wave of 66.73 dB has the maximum emission at a frequency of 80 Mhz, as shown in a region "A".

The chart illustrated in FIG. 5 shows results of noise measured in the plasma display apparatus including a heat sink grounded by a plurality of grounding portions that are spaced apart from one another at an interval that is approximately 1/20 of a wavelength of a frequency at which the maximum emission of electromagnetic waves is measured. In this experiment, an interval between the connection portions of the heat sink is about 10 cm.

As shown in a region "B" illustrated in FIG. 5, it can be seen that the maximum emission of electromagnetic waves is reduced by improving the grounding structure of the heat sink, since the intensity of electromagnetic wave is 60.3 dB at a frequency of 84 MHz. Therefore, some improvement is visible even above the calculated value of 1/20 of a wavelength.

While the present invention has been particularly shown and described with reference to exemplary embodiments thereof, it will be understood by one of ordinary skill in the art that various changes in form and details may be made therein without departing from the scope of the present invention as defined by the following claims.

## Claims

1. A circuit board assembly comprising:

   a circuit board (40);
   circuit elements (50) on the circuit board;
   a heat sink (60) contacting the circuit elements for dissipating heat generated by the circuit elements away from the circuit elements; and
   a plurality of grounding portions (70) spaced apart from one another on the heat sink, and connected to the circuit board for grounding the heat sink, wherein an interval between the grounding portions is arranged to reduce electromagnetic emission by the heat sink.

2. The circuit board assembly of claim 1, wherein the interval at which the grounding portions are spaced apart from one another is less than 1/20 of a wavelength ($\lambda$) of a frequency at which a maximum emission of electromagnetic radiation generated by the circuit elements occurs.

3. The circuit board assembly of claim 2, wherein the wavelength ($\lambda$) is calculated according to the equation

$$\lambda = \frac{C}{f\sqrt{\epsilon\mu}}$$

where "C" is the velocity of light, "$\epsilon$" is permittivity of a medium, "$\mu$" is permeability of a medium, and "f" is a frequency at which the maximum emission of electromagnetic radiation occurs.

4. The circuit board assembly of any one of the preceding claims, wherein the grounding portions protrude from the heat sink towards the circuit board.

5. The circuit board assembly of any one of the preceding claim, wherein the circuit board comprises grounding terminals on regions corresponding to the grounding portions.

6. The circuit board assembly of any one of the preceding claims, wherein the circuit board comprises through holes respectively housing the grounding portions, and grounding terminals respectively in the through holes for contacting the grounding portions.

7. A plasma display apparatus comprising:

   a plasma display panel (10);
   a chassis base (20) supporting the plasma display panel; and
   a circuit board assembly according to any one of the preceding claims, wherein the circuit board (40) is on the chassis base and electrically connected to the plasma display panel for applying driving signals to the plasma display panel.

8. A method for reducing emission of electromagnetic radiation from circuit elements on a heat sink mounted on a circuit board, comprising:

   providing ground terminals on the circuit board,
   coupling the heat sink to the circuit board by mounting portions connecting the heat sink to the ground terminals;
   spacing the mounting portions apart from one another at an interval that is arranged to reduce electromagnetic emission by the heat sink.

9. The method of claim 8, wherein the interval is less than 1/20 of a wavelength of a frequency at which a maximum emission of electromagnetic radiation generated by the circuit elements occurs.

10. The method of claim 8 or 9, wherein the electromagnetic radiation generated by the circuit elements is from driving signals for driving a plasma display panel.

# FIG. 1

# FIG. 2

# FIG. 3

# FIG. 4

Ref 70 dBµV       Atten 0 dB       Mkr1  80.0 MHz
                                      66.73 dBµV

Peak Log 5 dB/

Marker
80.000000 MHz
66.73 dBµV

Start 30 MHz                           Stop 300 MHz
Res BW 120 kHz       VBW 300 kHz      Sweep 40.76 (401 pts)

| Pk | X Axis | Amplitude | Pk | X Axis | Amplitude |
|---|---|---|---|---|---|
| 1 | 80.0 MHz | 66.73 dBµV | 6 | 209.6 MHz | 55.17 dBµV |
| 2 | 239.9 MHz | 59.25 dBµV | 7 | 152.9 MHz | 53.55 dBµV |
| 3 | 99.5 MHz | 58.3 dBµV | 8 | 264.2 MHz | 46.65 dBµV |
| 4 | 46.2 MHz | 55.53 dBµV | 9 | | |
| 5 | 179.9 MHz | 55.3 dBµV | 10 | | |

EP 2 048 927 A2

# FIG. 5

B

Mkr1  84.0 MHz
60.3 dBμV

Ref 70 dBμV          Atten 0 dB

Peak
Log
5
dB/

Marker
84.000000 MHz
60.3 dBμV

Start 30 MHz                                                    Stop 300 MHz
Res BW 120 kHz              VBW 300 kHz        Sweep 40.76 (401 pts)

| Pk | X Axis | Amplitude | Pk | X Axis | Amplitude |
|---|---|---|---|---|---|
| 1 | 84.0 MHz | 60.3 dBμV | 6 | 258.8 MHz | 44.98 dBμV |
| 2 | 119.1 MHz | 59.32 dBμV | 7 | 252.8 MHz | 42.95 dBμV |
| 3 | 179.9 MHz | 54.69 dBμV | 8 | 275.7 MHz | 40.28 dBμV |
| 4 | 39.5 MHz | 53.14 dBμV | 9 | | |
| 5 | 239.9 MHz | 49.49 dBμV | 10 | | |

EP 2 048 927 A2